# EUROPÄISCHE PATENTSCHRIFT

(11) **EP 2 617 063 B1**
(45) Veröffentlichungstag und Bekanntmachung des Hinweises auf die Patenterteilung: **30.07.2014**
(21) Anmeldenummer: 11751608.8
(22) Anmeldetag: 02.09.2011
(51) Int. Cl.: H01L 31/042, F24J 2/00

(54) **SEILWERK ZUR SCHWENKUNG EINES TRAGAUFBAUES FÜR FOTOVOLTAIKMODULE ODER VERGLEICHBARE VORRICHTUNGEN**
CABLE INSTALLATION FOR PIVOTING A SUPPORT STRUCTURE FOR PHOTOVOLTAIC MODULES OR COMPARABLE DEVICES
MÉCANISME DE CÂBLES POUR LE PIVOTEMENT D'UNE STRUCTURE SUPPORT POUR DES MODULES PHOTOVOLTAÏQUES OU DES DISPOSITIFS ANALOGUES

(30) Priorität: 13.09.2010 IT BZ20100034
(43) Veröffentlichungstag der Anmeldung: 24.07.2013
(73) Patentinhaber: Czaloun, Johann, 39012 Meran (IT)
(72) Erfinder: Czaloun, Johann, 39012 Meran (IT)
(74) Vertreter: Müller Schupfner & Partner Patent- und Rechtsanwaltspartnerschaft mbB
(86) Internationale Anmeldenummer: PCT/EP2011/065209
(87) Internationale Veröffentlichungsnummer: WO 2012/034873

(56) Entgegenhaltungen:
- WO-A2-2010/054831
- US-A- 4 585 318
- US-A1- 2010 018 566

## Beschreibung

Die vorliegende Erfindung betrifft ein Seilwerk zur Schwenkung eines Tragaufbaues für Fotovoltaikmodule oder vergleichbare Vorrichtungen, wie Sonnenwärmekonzentratoren oder Solarpaneelen gemäß dem Oberbegriff des Anspruchs 1.

Fotovoltaikmodule werden teilweise auf Tragkonstruktionen montiert, die auf einer oder zwei Achsen der Sonne folgen. Der Hauptvorteil dieser beweglichen Tragkonstruktionen, bekannt als "Mover" gegenüber den fest verankerten, ist die höhere Stromausbeute mit ein und derselben aktiven Moduloberfläche.

Eine besondere Problematik bei größeren Oberflächen, die im Freien erstellt werden, ist unter anderem durch die Windkräfte gegeben, die auch den Einstellwerken übertragen werden und unter ungünstigen Verhältnissen, die in Betracht zu ziehen sind, in diesen zu starke Beanspruchungen erzeugen. Das Dokument US 2010/018566 A beschreibt ein Solarmodul.

Übliche Einstellwerke werden größtenteils durch Zylinder, Zahnsegmente, Schrauben oder ähnlichen Elementen betätigt, deren gemeinsamer Nachteil vor allem in der Tatsache besteht, dass durch Windkräfte verursachte Drehmomente über verhältnismäßig kleine Hebelarme aufgenommen werden, und somit große Kräfte im Einstellwerk selbst sowie auch in den Verankerungsstellen verursachen.

Somit ist ein Einstellwerk zu finden, dessen Eingriffsstellen am schwenkbaren Tragaufbau sich möglich weit nach außen versetzt befinden, ohne jedoch dass überdimensionierte Verstellelemente erforderlich werden. Eine Möglichkeit wäre durch Einstellseile oder vergleichbaren biegsamen Zugelementen gegeben, die am zu verschwenkenden Tragaufbau befestigt werden. Es sind derartige Systeme bekannt, die jedoch den Nachteil haben, Kreissegmente erforderlich zu machen, die mit der Schwenkachse konzentrisch und mit dem zu verschwenkenden Tragaufbau verbunden sind und auf denen die Einstellseile auf einer der Seiten aufwickeln und entsprechend auf der anderen abwickeln. Nur mit dieser Geometrie kann erreicht werden, dass die Seillänge, die mit der Verschwenkbewegung aufgewickelt wird, gleich jener ist, die abgewickelt wird, im Falle wenn die Bewegung des Einstellseiles durch eine herkömmliche, durchgehende Winde bewerkstelligt wird.

Die Eingriffsstellen des Einstellseils müssen - wie erwähnt -aus statischen Gründen weitgehend beabstandet sein. Dieser Abstand entspricht, in den bekannten Lösungen, dem Durchmesser von sich mitdrehenden Kreissegmenten, wodurch derartige Einstellvorrichtungen große Abmessungen annehmen können. Ein weiterer Nachteil der herkömmlichen Lösungen, bei denen das Einstellseil sich auf Kreissegmenten aufwickelt bzw. abwickelt, besteht darin, dass die Winde für die Betätigung des Einstellseils an der Seite befestigt werden muss, die jener mit den Kreissegmenten abgewandt ist. Dies bedeutet üblicherweise einen zusätzlichen Konstruktionsaufwand, da die Einstellwerke nicht mehr auf dem Schwenkteil vereint werden können.

Die Veröffentlichung US 2010/018566 beschreibt ein Gerät zur Umformung in einem Fotovoltaikstrom, das ein oder mehrere Ballons unter Einschluss von Gas, das leichter ist als Luft, mit einem oder mehreren Sonnenenergiepaneels auf einer Grundfläche, ein oder mehrere Sonnenenergiepaneels, die von einem oder von mehreren Ballonen befestigt ist, wobei ein oder mehrere Ballone an einem oder mehreren Solarenergiepaneels befestigt sind, wobei ein Gewicht vorgesehen ist, das mit einem Ende an einem oder mehreren Paneels und am zweiten Ende an einer Grundfläche befestigt ist, wobei ein Ladungsüberprüfungsgerät zur Einstellung von einem oder mehreren Energiepaneels mit einem Batteriesystem verbunden ist; und ein Batteriesystem für die elektrische Ladung.

Das in dieser Vorveröffentlichung beschriebene Seilsystem erlaubt die Nachführung von Paneelen auf Ballons als Trägeraufbau, wobei ein Längenausgleich der Seile nicht notwendig ist.

Das europäische Patent 0 114 240 zeigt hingegen eine Nachführungseinrichtung zur genauen oder angenäherten Nachführung von Geräten nach einer bogenförmigen Bahn, beispielsweise von solartechnischen Empfängern oder Reflektoren, wobei die Bewegung des Gerätes um zwei Achsen erfolgt und die Bewegung um die zweite Achse zwangsweise mit der Bewegung um die erste Achse durch mindestens ein Führungsglied mit einem mitbewegtem Gelenkpunkt gekoppelt ist und das Führungsglied um einen bezüglich der Hauptbewegung nicht mitbewegten Gelenkpunkt schwenkt, welcher außerhalb der ersten Achse des Gerätes liegt, wobei die Achsen sich schneiden und das Führungsglied so angeordnet ist, dass sich der mitbewegte Gelenkpunkt bei einem Kreispunkt bewegt, dessen Mittelpunkt der Schnittpunkt der Achsen ist und die Verbindungslinie zwischen diesem Schnittpunkt und dem nicht bewegten Gelenkpunkt genau oder angenähert parallel zur Erdachse bzw. zur Flächennormalen der Bahn verfolgten Objektes ist.

Diese Nachführungseinrichtung ist sehr kompliziert in in ihrer Ausführung und ist aufgrund ihrer Lagerung an einer der Achsen auch in der Tragkonstruktion aufwändig und schwierig zu erzielen.

Die Aufgabe der vorliegenden Erfindung ist die Behebung der Nachteile der herkömmlichen Seilwerke und der Vorschlag eines einfacheren Seilwerkes mit der Möglichkeit die Angriffsstellen der Seilenden weitmöglichst zu beabstanden.

Diese Aufgabe wird erfindungsgemäß durch ein Seilwerk gemäß dem kennzeichnenden Teil des Anspruchs 1 gelöst.

Es wird ein Seilwerk mit einem Tragaufbau, beispielsweise eine Stange oder ein Tragrahmen vorgeschlagen, diese bzw. dieser kann an einem Basisaufbau um eine erste Achse angelenkt werden, wobei an den Enden des Tragaufbaus jeweils eine Umlenkrolle drehbar vorgesehen ist, die für ein Seil vorgesehen ist, das an einem Ende an einer Stelle des Tragaufbaues befestigt ist, während das andere Ende des Seils an einer zweiten Stelle des Basisaufbaues befestigt ist, die von der ersten Stelle beabstandet werden kann, wobei zwischen den Umlenkrollen das Seil auf einer Trommel aufwickel- und abwickelbar ist, die zur ersten Achse senkrecht ist, wobei das Seil mit einem Wickeldurchmesser gegenüber der Trommelachse aufwickelbar bzw. abwickelbar ist.

In einer bevorzugten Ausführungsform weist die Trommel einen Körper auf, der sich in Richtung der Trommelenden verjüngt und schraubenförmige Rillen besitzt, die das Seil aufnehmen.

In einer Variante ist der Tragaufbau eine Stange oder jeweils eine mit dieser verbundenen Tragoberfläche, bei der die Verschwenkbewegung der Stange durch ein Seil erzielt wird, das an den Enden der Stange um die Umlenkrollen herum geführt, an seinen Enden an den Verankerungsstellen verankert ist und durch eine Winde bewegt wird, die zwischen den Umlenkrollen auf der drehbaren Stange befestigt ist, wobei das Verhältnis der Seillänge, die aufgewickelt bzw. abgewickelt ist, veränderbar ist und in jeder Position im Verhältnis der Längenänderung im Bereich zwischen der Achse einer der Umlenkrollen und der Verankerungsstelle einer der Enden des Seils bzw. zwischen der Achse der anderen Umlenkrolle und der Verankerungsstelle des anderen Endes des Seils entspricht.

In einer anderen Ausführungsform ist das veränderliche Verhältnis zwischen aufwickelnden Seilzweig bzw. abwickelnden Seilzweig auf der Winde durch eine Seiltrommel erreicht, in der der Durchmesser der Rillen für das Seil, die schraubenförmig angeordnet sind, entsprechend der geometrischen Verhältnisse angepasst wird, die in jeder Position gegeben sind. Das Seil kann durchgehend sein und mehrmals aufgewickelt sein, oder im Bereich der Trommel selbst geteilt sein und mit den jeweiligen Enden an derselben eingeklemmt sein.

In einer anderen Ausführungsform mit durchgehender Winde, ausgeführt mittels einer Seiltrommel, wird eine Seilabwicklung, bevorzugter Weise jene mittige, mittels einer federbelasteten Spannrolle von der Seiltrommel weggezogen, wodurch Änderungen in der Gesamtlänge des Seilringes während des Einstellvorgangs ausgeglichen werden können, bzw. das gesamte Seilsystem besitzt eine vorgegebene Vorspannung innerhalb bestimmter Grenzen.

Weitere Merkmale und Einzelheiten des Seilwerkes gemäß der Erfindung gehen aus den Patentansprüchen und aus der Beschreibung einer bevorzugten Ausführungsform hervor, die in den Figuren der beigefügten Zeichnung dargestellt ist. Es zeigen
- Figur 1: schematisch einen Tragaufbau eines Fotovoltaikmoduls, in Perspektive,
- Figur 2: eine Einzelheit aus Figur 1, und
- Figur 3: eine durchgehende Winde mit veränderlichem Durchmesser.

In der Figur ist mit der Bezugsziffer 1 in seiner Gesamtheit ein Fotovoltaikmodul angegeben.

Das Fotovoltaikmodul 1 wird von einem Tragaufbau in der Form einer Stange frei getragen, die ihrerseits durch einen Basisaufbau in der Form eines Zweifußes 3 um eine Achse 4 und aus Stabilitätsgründen einer Stütze 5 getragen wird.

Ein Einstellseil 6 ist an seinen beiden Enden im Bereich beider Aufliegestellen 7 und 8 des Zweifußes 3 bzw. an der Basiskonstruktion verankert. Das Einstellseil 6 ist bevorzugter Weise ein Stahlseil, und kann jedoch auch in der Form von Textilseilen, Bändern, Ketten oder ähnlichen Gliedern ausgeführt sein.

Aufgrund der festen Verankerung der Seilenden in den Stellen 7 und 8 bildet das Einstellseil 6, geführt um zwei Umlaufrollen 9 und 10 im Wesentlichen parallel zur Achse 4, eine geschlossenen Ring.

Eine durchgehende Winde 11, die senkrecht zur Achse 4 ist, und an der Stange 2 zwischen den Umlenkrollen 9 und 10 festliegt, bewegt den Seilring je nach Drehsinn der Seiltrommel nach links oder nach rechts oder umgekehrt.

Die Problematik in diesem Fall liegt darin, dass der Abstand 9 - 7 bei der Drehung der Stangen 2 nicht im selben Maße verlängert bzw. verkürzt wird, wie der Abstand 8 - 10 auf der entgegen gesetzten Seite. Im Fall einer herkömmlichen zylindrischen Seiltrommel wäre dies mit einer Spannung oder einer Lockerung des Einstellseils verbunden.

Um diese unzulässige Änderung der Gesamtlänge des Rings des erfindungsgemäßen Einstellseils zu verhindern wird die Trommel der durchgehenden Winde 11 nicht zylindrisch ausgebildet, sondern mit einem Aufwickeldurchmesser, der längs der Trommelachse veränderlich ist. Die Forderung nach einer könstanten Gesamtlänge des Rings des Einstellseils 6 in der Verschwenkung der Stange 2 wird dadurch erreicht, dass die verschiedenen Aufwickeldurchmesser für das aufwickelnde bzw. abwickelnde Einstellseil 6 die ungleichen Änderungen der Abschnitte 9 - 7 und jeweils 10 - 8 ausgleicht.

Eine Seiltrommel, die diese Forderung erfüllt, ist in den Figuren dargestellt. Sie besitzt Seilrillen, die schraubenförmig 12 derart angeordnet sind, dass bei seiner Drehung die Stellen, in denen das Seil sich tangential aufwickelt bzw. abwickelt, sich längs der Achse der Seiltrommel verändern.

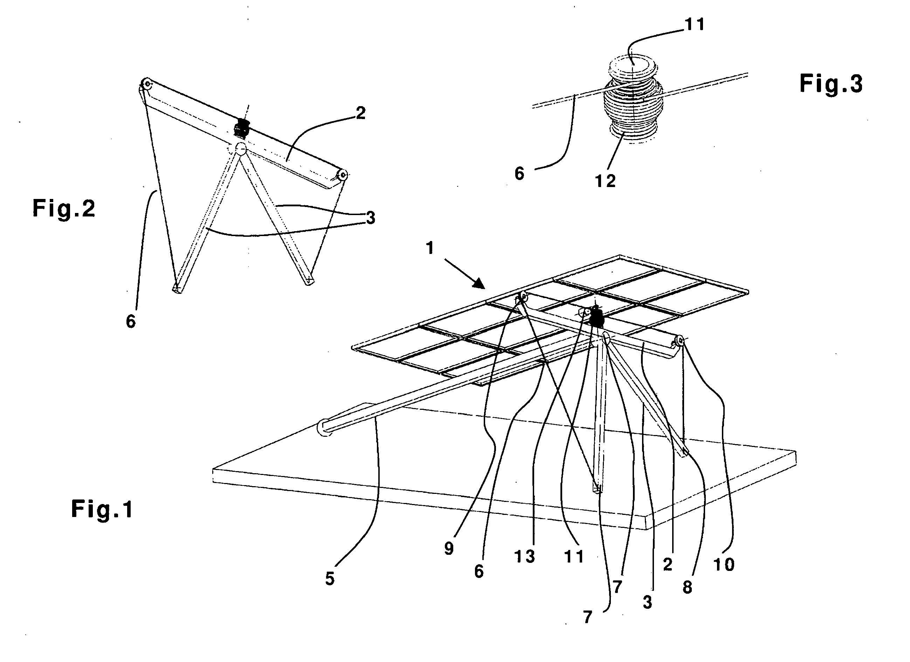

Die Zuordnung des Aufwickeldurchmessers für das aufwickelnde bzw. das abwickelnde Seil an die jeweilige Seitenposition der Seilaufwicklungen gemäß der Erfindung entspricht im Wesentlichen der gewölbten Form, die besser aus Figur 3 hervorgeht.

Im Grunde ist es möglich die Mitnahme des Einstellseils von der Trommel nur über Reibung zu erzielen oder das Seil kann an die Trommel gebunden werden, in einer Stelle, an der es nicht angehoben wird, durch eine nicht dargestellte Klemme. Es ist aber auch möglich das Seil an der Trommel zu unterbrechen und die Enden der Klemmen an dieser zu befestigen (Figur 3 ohne Angabe der Klemmen).

Bei einer Befestigung des Seils an der Trommel mittels Klemmen, ist keine Notwendigkeit gegeben, den jeweils belasteten Seilzweig vorzuspannen.

Bei der Mitnahme des Seils auf der Trommel mit Reibung, so wie dargestellt, besteht die Notwendigkeit einer Vorspannung im entlasteten Teil, um einen Schlupf zu verhindern. Es ist die Tatsache zu berücksichtigen, dass die Beanspruchung im Seilsystem in Betrieb je nach Drehrichtung, der Windstärken, der Verteilung des Gewichtes usw. laufend ihre Richtung ändert. Diese Vorspannung kann auf verschiedenen Arten und Weisen sichergestellt werden, z.B. mittels eines Federzuges oder Federelementen im Seilsystem.

Ein Spannsystem, das in Zusammenwirkung mit der Seiltrommel 6 die notwendige Mindestspannung garantiert, unabhängig von welcher Seite die Belastung eingeleitet wird, ist durch einen Seilspanner gebildet.

In diesem Fall ist erfindungsgemäß die mittige der Seilwicklungen auf der Trommel durch eine Spannrolle weggezogen, die mittels einer Feder von der Trommel verstellbar ist.

Die Federkraft wird derart bemessen, dass die damit erzeugte Vorspannung ausreicht, um an der jeweils belasteten Seite die notwendige Schlupfsicherheit herzustellen. Die auf der belasteten Seite höchstens übertragbare Seilkraft ist ein Vielfaches größer gegenüber der in der Feder erzeugten Seilspannung. Das Verhältnis zwischen diesen Seilkräften, ergibt sich, um die Schlupfgefahr auszuschließen, gemäß einer bekannten Formel durch die Anzahl der Windungen und die Reibungszahl zwischen Seil und Trommel. Eine Möglichkeit, die Haftung des Seils auf der Trommel zu erhöhen, besteht z.B. in trapezförmigen Seilrillen (nicht gezeichnet).

Die Federspannung gewährleistet auch im nicht belasteten Seilzweig mindestens eine niedrige Vorspannung und kann überdies Formfehler der Trommel ausgleichen, bis zu dem Punkt, dass die Änderungen in der Länge im Ring vollständig ausgeglichen werden, wenn die Trommel zylindrisch ausgeführt ist.

Zweckmäßiger Weise weist die durchgehende Winde 11 eine Achse auf, die mit einem Antrieb 13 verbunden ist, der die Winde 11 selbst antreibt und bevorzugter Weise in Abhängigkeit der Sonne für eine größtmögliche Sonneneinstrahlung des Fotovoltaikmoduls gesteuert wird.

## Patentansprüche

1. Seilwerk mit einem Tragaufbau (2) für Fotovoltaikmodule oder vergleichbare Vorrichtungen, wie Sonnewärmekonzentratoren oder Solarpaneele, der an einem Basisaufbau (3) um eine erste Achse angelenkt ist, **dadurch gekennzeichnet, dass** an Enden des Tragaufbaues (2) jeweils eine drehbare Umlenkrolle (9, 10) vorgesehen ist, für ein durchgehendes Übertragungsglied, das an einem Ende an einer Stelle (7) des Basisaufbaues (3) befestigt ist, während das andere Ende des durchgehenden Gliedes (6) an einer Stelle (8) des Basisaufbaues (3) befestigt ist, wobei zwischen den Umlenkrollen (9, 10) das durchgehende Glied (6) auf einer Winde (11) aufwickelbar bzw. abwickelbar ist.

2. Seilwerk nach Anspruch 1, **dadurch gekennzeichnet, dass** der Tragaufbau eine Stange (2) ist.

3. Seilwerk nach Anspruch 1, **dadurch gekennzeichnet, dass** das durchgehende Übertragungsglied ein Seil (6) ist.

4. Seilwerk nach Anspruch 1, **dadurch gekennzeichnet, dass** die Winde (1) eine Trommel aufweist, die einen Körper besitzt, der sich in Richtung der Enden der Trommel verjüngt und schraubförmige, seilaufnehmende Rillen besitzt.

5. Seilwerk nach Anspruch 1 und 4, **dadurch gekennzeichnet, dass** das veränderliche Verhältnis zwischen aufwickelnden bzw. abwickelnden Seilzweig (6) an der Winde (6) durch die Trommel erzielt wird, welche die schraubenförmigen Rillen (12) aufweist, bei denen der Rillendurchmesser für das Seil entsprechend den Formverhältnissen angepasst wird, die in jeder Position zwischen dem aufwickelnden Zweig und jenem abwickelnden des durchgehenden Übertragungsgliedes (6)auftreten.

6. Seilwerk nach Anspruch 1 und 3, **dadurch gekennzeichnet, dass** mit einer durchgehenden, mittels der Trommelwinde (11) ausgeführten Winde, eine Seilwicklung (6), bevorzugter Weise jene mittige, mittels einer federbelasteten Spannrolle von der Seiltrommel weggezogen wird, wodurch Änderungen in der Gesamtlänge des Seilringes während des Einstellvorganges ausgeglichen werden bzw. das gesamte Seilsystem besitzt eine innerhalb bestimmter Grenzen festgelegte Vorspannung.

7. Seilwerk nach den vorstehenden Ansprüchen, **dadurch gekennzeichnet, dass** das durchgehende Übertragungsglied aus zwei Teilen besteht, von denen jedes eines seiner Enden an der Trommel befestigt hat.

## Claims

1. Cable installation with a support structure (2), for photovoltaic modules or comparable installations such as solar concentrators or solar panels, that is hinged to a base structure (3) about a first axis, **characterized in that** a rotatable deviation roller (9, 10) is provided at each end of the support structure (2), for a continuous transmitting element that is fixed at one end to an area (7) of the base structure (3) while the other end of the continuous element (6) is fixed to an area (8) of the base structure (3) wherein the continuous element (6) can be wound or unwound on a winch (11) between the deviating rollers (9, 10).

2. Cable installation according to claim 1 **characterized in that** the support structure is a rod (2).

3. Cable installation according to claim 1 **characterized in that** the continuous transmitting element is a cable (6).

4. Cable installation according to claim 1 **characterized in that** the winch (1) comprises a drum having a body tapering towards the ends of the drum and having helical cable accommodating grooves.

5. Cable installation according to claim 1 and 4 **characterized in that** the variable ratio between the cable branches (6) to be wound and unwound, respectively, on the winch (6) is achieved by the drum which has the helical grooves (12) wherein the groove diameter for the cable is adapted in correspondence to the form condition arising in each position between the branch to be wound and that to unwound of the continuous transmitting element (6).

6. Cable installation according to claim 1 and 3 **characterized in that** by way of a continuous winch which is realized by a drum winch (11) a cable winding (6), preferably the central one, is drawn off the cable drum by a spring loaded tension roll, whereby variation in overall length of the cable ring during the adjustment procedure will be compensated or the entire cable system has a pretension which is defined within certain limits, respectively.

7. Cable installation according to one of the preceding claims **characterized in that** the continuous transmitting element consists of two parts each one of which having fixed one of its ends on the drum.

## Revendications

1. Mécanisme à câble comprenant une structure portante (2) pour des modules photovoltaïques ou des dispositifs similaires comme des concentrateurs thermiques solaires ou des panneaux solaires, qui est articulée autour d'un premier axe sur une structure de base (3), **caractérisé en ce qu'**il est prévu aux extrémités de la structure portante (2) un rouleau de renvoi rotatif respectif (9, 10), pour un organe de transmission continu qui est fixé à une extrémité à un emplacement (7) de la structure de base (3) alors que la seconde extrémité de l'organe continu (6) est fixée à un emplacement (8) de la structure de base, et l'organe continu (6) est susceptible d'être enroulé ou respectivement déroulé sur un treuil (11) entre les rouleaux de renvoi (9, 10).

2. Mécanisme à câble selon la revendication 1, **caractérisé en ce que** la structure portante est une barre (2).

3. Mécanisme à câble selon la revendication 1, **caractérisé en ce que** l'organe de transmission continu est un câble (6).

4. Mécanisme à câble selon la revendication 1, **caractérisé en ce que** le treuil (1) comprend un tambour qui possède un corps qui va en se rétrécissant direction des extrémités du tambour et qui possède des rainures de forme hélicoïdale qui reçoivent le câble.

5. Mécanisme à câble selon la revendication 1 et 4, **caractérisé en ce que** le rapport variable entre le brin de câble qui s'enroule ou respectivement le brin de câble qui se déroule (6) sur le treuil (6) est obtenu par le tambour qui comporte les rainures de forme hélicoïdale (12), dans lesquelles le diamètre de rainures est adapté pour le câble en correspondance des relations de formes qui se présentent dans chaque position entre le brin qui s'enroule et le brin qui se déroule de l'organe de transmission continu (6).

6. Mécanisme à câble selon la revendication 1 et 3, **caractérisé en ce qu'**au moyen d'un treuil continu, réalisé au moyen du treuil à tambour (11), une spire du câble (6), et de manière préférée la spire centrale, est tirée en éloignement du tambour à câble au moyen d'un galet de tensionnement chargé par un ressort, grâce à quoi des modifications de la longueur totale de la boucle de câble pendant l'opération de réglage sont compensées, ou respectivement la totalité du système à câble possède une précontrainte fixée à l'intérieur de limites déterminées.

7. Mécanisme à câble selon les revendications précédentes, **caractérisé en ce que** l'organe de transmission continu est constitué de deux parties, dont chacune est fixée sur le tambour par l'une de ses extrémités.
